(19) Europäisches Patentamt / European Patent Office / Office européen des brevets

(11) **EP 2 714 603 B1**

(12) **EUROPÄISCHE PATENTSCHRIFT**

(45) Veröffentlichungstag und Bekanntmachung des Hinweises auf die Patenterteilung:
**12.07.2017 Patentblatt 2017/28**

(21) Anmeldenummer: **12720178.8**

(22) Anmeldetag: **10.05.2012**

(51) Int Cl.:
*C03B 37/014* (2006.01)     *C03B 37/018* (2006.01)
*C03B 37/012* (2006.01)

(86) Internationale Anmeldenummer:
**PCT/EP2012/058599**

(87) Internationale Veröffentlichungsnummer:
**WO 2012/163644 (06.12.2012 Gazette 2012/49)**

(54) **VERFAHREN ZUR HERSTELLUNG EINES HALBZEUGS ZUR FERTIGUNG EINER BIEGEOPTIMIERTEN LICHTLEITFASER**

METHOD FOR PRODUCING A SEMIFINISHED PART FOR THE MANUFACTURE OF AN OPTICAL FIBER WHICH IS OPTIMIZED IN TERMS OF BENDING

PROCÉDÉ DE FABRICATION D'UN DEMI-PRODUIT DESTINÉ À LA FABRICATION D'UNE FIBRE OPTIQUE OPTIMISÉE EN FLEXION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.05.2011 DE 102011110246**
**11.11.2011 DE 102011118268**

(43) Veröffentlichungstag der Anmeldung:
**09.04.2014 Patentblatt 2014/15**

(73) Patentinhaber: **J-Plasma GmbH**
**07551 Jena (DE)**

(72) Erfinder:
• **BREHM, Lothar**
**07743 Jena (DE)**
• **AUTH, Matthias**
**45289 Essen (DE)**
• **KÖTZING, Jörg**
**07747 Jena (DE)**

(74) Vertreter: **Kruspig, Volkmar**
**Meissner Bolte Patentanwälte**
**Rechtsanwälte Partnerschaft mbB**
**Geschwister-Scholl-Strasse 15**
**07545 Gera (DE)**

(56) Entgegenhaltungen:
**EP-A1- 1 256 554        EP-A2- 1 388 525**
**WO-A1-01/72648          WO-A1-2011/110617**
**DE-A1-102006 031 898    JP-A- 3 016 930**
**JP-A- 2001 192 233      US-A1- 2006 204 189**

**Beschreibung**

Die Erfindung betrifft ein Verfahren zur Herstellung eines Halbzeugs zur Fertigung einer biegeoptimierten Lichtleitfaser nach Anspruch 1 und eine aus dem Halbzeug gefertigte Lichtleitfaser.

Biegeoptimierte Lichtleitfasern weisen ein auf den jeweiligen Anwendungszeck abgestimmtes Biegeverhalten, insbesondere eine darauf angepasste Biegeempfindlichkeit hinsichtlich ihrer Lichtleitfähigkeit, auf. Dies betrifft einerseits Lichtleitfasern, die eine besonders ausgeprägte Biegeempfindlichkeit zeigen sollen, wie zum Beispiel Sensorfasern in optischen Biegesensoranordnungen und Lichtleitfasern, die möglichst wenig biegeempfindlich sein sollen, wie zum Beispiel Lichtleitfasern, die zur Übermittlung von Daten mit einer hohen Bandbreite benötigt werden.

Derartige Lichtleitfasern weisen einen Querschnitt mit einem strukturierten Brechzahlprofil auf. Dies betrifft insbesondere Grabenstrukturen, Graduierungen oder auch komplizierte Kombinationen aus mehreren Gräben verschiedener Breite und zwischengelagerten brechzahlerhöhten Stegen. Derartige Fasern sind mit den herkömmlichen Mitteln, d.h. den bekannten chemischen und/oder physikalischen Abscheideverfahren nur sehr kompliziert zu fertigen, weil dabei die Abscheideparameter bei dem bei diesen OVD Prozessen, inbesondere dem POVD Prozess nur sehr schwer zu reproduzieren sind. Dieses führt dazu, dass der schwerst einzustellende Parameter am Ende des Fertigungsprozesses eingestellt wird und so im ungünstigen Fall im letzten Schritt ein Totalverlust des Halbzeugs droht.

Bekannt sind Verfahren zur Herstellung von Preformen, bei denen Rohre aufeinander aufkollabiert werden.

Beispielsweise offenbart die EP 1 388 525 A2 ein Verfahren zur Herstellung von Preformen, bei dem auf einen Kernstab ein Rohr aufkollabiert werden kann. Die Lehre der Druckschrift betrifft keine biegeunempfindlichen Fasern oder die Verbesserung der Biegeeigenschaften. Die Druckschrift lehrt ein Verfahren zum Einbringen einer Schicht mit einer bestimmten Viskosität im Bereich eines äußeren Claddings.

Die JP 2001 92233 offenbart eine optische Faser und ein hierfür vorgesehenes Herstellungsverfahren. Gemäß der Lehre dieser Druckschrift sollen verschiedene Schichten verwendet werden. Es wird ein F-dotierter Kern verwendet, der mit einer GeO2-Schicht umgeben ist. Diese ist wiederum von einer F-dotierten SiO2-Schicht umgeben. Daraus ergibt sich ein Faseraufbau, bei dem der Kern keine höhere Brechzahl hat als das umgebende Cladding. Damit ist diese Faser zur Datenübertragung im Telekommunikationsbereich nicht geeignet. Die Zwischenschicht dient dazu, die Konzentrationsgradienten zu minimieren.

Die EP 1 256 554, bzw. die DE 602 09 457 T2 offenbaren eine optische Stufenindexfaser mit dotiertem Kern und Mantel, eine Vorform und ein Herstellungsverfahren für eine solche Faser. Gemäß der dort offenbarten Lehre wird ein bereits dotiertes Substratrohr verwendet, in dem ein Kern abgeschieden wird. Weiterhin werden gemäß der Lehre der Druckschriften Hülsen aufkollabiert, um den Kern/Außendurchmesser der Preform einzustellen.

Die JP 0 301 6930 offenbart ein Verfahren zur Herstellung eine Faser mit einer komplizierten Brechzahlverteilung. Dabei wird um ein Rohr eine Sootschicht abgeschieden. In das Rohr wird gemäß der Lehre der Druckschrift ein Stab eingeschoben. Der gesamte Aufbau wird anschließend verschmolzen und verglast.

Die US2006/0204189 offenbart eine Lehre zur Herstellung einer Preform für eine optische Faser, ein Herstellungsverfahren und eine optische Faser. Verwendet wird dort ein Substratrohr, das mit einer Innenabscheidungstechnik verarbeitet wird. Dabei werden alle Kern/Mantelschichten innerhalb des Rohres abgeschieden. Ein zweites Rohr wird beim Ziehen aufkollabiert. Damit wird lediglich ein Aufdicken der Preform bezweckt, um das Verhältnis Kern/Manteldurchmesser einzustellen.

Die WO01/726 offenbart ein Substratrohr und ein Verfahren zum Herstellen einer Preform für eine optische Faser. Gemäß der dort enthaltenen Lehre wird ein poröser Sootkörper mit verschiedenen Dotanden versehen und beim Verglasen werden direkt die einzelnen Schichten hergestellt.

Es besteht daher die Aufgabe, ein wirtschaftliches und effektives Verfahren zur Herstellung eines Halbzeugs zur Herstellung der biegeoptimierten Faser anzugeben, wobei das geforderte Brechzahlprofil sowohl exakt planbar als auch mit einem minimierten Zeitaufwand gefertigt werden kann.

Die Aufgabe wird mit einem Verfahren zur Fertigung eines Halbzeugs zur Herstellung einer biegeoptimierten Lichtleitfaser mit den Merkmalen des Anspruchs 1 gelöst. Die Unteransprüche enthalten zweckmäßige Ausführungsformen und Gestaltungen des Verfahrens.

Die Fertigung umfasst das Herstellen oder ein Bereitstellen mindestens eines als Träger für die in den nächsten Schritten ausgeführten Beschichtungen und Oberflächenmodifikationen dienenden Mantelrohres mit einer im Vergleich zum lichtführenden Kern niedrigeren Mantelbrechzahl. Danach erfolgt ein Aufbringen mindestens einer eine diffusionsverhindernde Sperrfunktion gegenüber flüchtigen Glasbestandteilen besitzenden Schutz-, Zwischen- und/oder Barriereschicht auf einer radial äußersten und/oder innersten Rohroberfläche des jeweiligen Mantelrohres, wobei auf der Innenseite und/oder der Außenseite des Mantelrohres ein Aufbau lichtführender Schichten erfolgt. Es erfolgt schließlich ein zumindest teilweises Kollabieren und/oder Aufkollabieren des so hergestellten Mantelrohres zu einer Kapillare oder einem Stab.

Das Verfahren zeichnet sich erfindungsgemäß dadurch aus, dass in einem abschließenden konvergierenden Fertigungsprozess die mit den inneren und/oder äußeren Beschichtungen versehenen Mantelrohre zu dem Halbzeug vereinigt werden, wobei in einer Folge von Aufkollabierungen ein aufkollabierendes Zusammenfügen der Mantelrohre auf das Substrat zur Herstellung des Halbzeugs erfolgt. Dabei erfolgt der auf der Innenseite des Mantelrohres erfolgende Aufbau der lichtführenden Schichten mittels eines CVD- oder eines PIVD-Abscheideverfahrens, wobei sich die Brechzahl die Brechzahl ab einer bestimmten Schichtanzahl kontinuierlich erhöht.

Bei einer zweckmäßigen Ausgestaltung erfolgt ein weiteres aufkollabierendes Zusammenfügen zusätzlicher Mantelrohre auf den Stab, wobei der Stab als Substrat dient. Dabei erfolgt die Herausbildung des Halbzeugs, wobei die chemische Zusammensetzung der einzelnen Mantelrohre verschieden sein kann.

Bei einer ersten Ausführungsform wird das Mantelrohr in Form eines mit Fluor dotierten Quarzglasrohres bereitgestellt. Dadurch wird eine Brechzahlreduzierung im Material des Mantelrohres erreicht.

In einer bevorzugten Ausführungsform wird auf ein undotiertes Quarzglasrohr eine fluordotierte Schicht gewünschter Dicke und Brechzahl abgeschieden, auf die wiederum eine Beschichtung mit undotiertem Quarzglas als Schutzschicht erfolgt.

Bei einer weiteren zweckmäßigen Ausführungsform wird der Aufbau der lichtführenden Schichten mittels eines CVD-, insbesondere des MCVD Verfahrens, und/oder und/oder eines OVD-Verfahrens, insbesondere des Plasmaverfahrens und/oder einer Flammenpyrolyse ausgeführt.

Die Schutz-, Zwischen- und/oder Barriereschicht ist vorzugsweise aus einem Quarzglas mit einem höheren Schmelzpunkt im Vergleich zu dem Schmelzpunkt des Materials des Mantelrohres ausgeführt. Dadurch lässt sich eine erhöhte Stabilität des späteren Halbzeugs erreichen und es werden Ovalitäten und Exzentritäten im Aufbau reduziert.

Die Schutz-, Zwischen- und/oder Barriereschicht besitzt eine diffusionsverhindernde Sperrfunktion gegenüber flüchtigen Glasbestandteilen, insbesondere Brechzahl verändernden Dotanden und/oder insbesondere Fluor. Dadurch wird der Brechzahlverlauf stabilisiert und kann gegebenenfalls in weiteren Produktionsschritten noch zu einem gegebenen Zeitpunkt modifiziert werden.

Zugleich kann die Schutz-, Zwischen- und/oder Barriereschicht noch eine weitere Funktion erfüllen. Die Schutz-, Zwischen- und/oder Barriereschicht weist bei einer zweckmäßigen Ausbildung eine chemische Zusammensetzung auf, die beim Aufbringen des Halbzeugs auf ein weiteres Substrat, die thermischen, physikalischen und/oder chemischen Unterschiede zwischen dem Halbzeug und dem weiteren Substrat, insbesondere die Unterschiede der thermischen Ausdehnungskoeffizienten und/oder die unterschiedlichen chemischen Zusammensetzungen, minimiert. Dabei kann diese Schicht auch aus mehreren Übergangsgläsern unterschiedlicher chemischer Zusammensetzung bestehen.

Dadurch werden die Spannungen in dem dabei entstehenden Gesamtsystem minimiert oder auf eine zweckmäßige Größe eingestellt.

Nach dem Aufbau der lichtführenden Schichten kann eine Abscheidung mindestens einer weiteren inneren und/oder äußeren Schutz-, Zwischen- und/oder Barriereschicht ausgeführt werden. Dadurch wird das modifizierte Mantelrohr entweder innen oder außen oder auf beiden Seiten entsprechend präpariert.

An dem Mantelrohr erfolgt bei einer zweckmäßigen Ausgestaltung mit Hilfe mindestens eines Druckregelsystems ein gezieltes Einstellen eines Umgebungsdruckes und/oder eines Rohrinnendruckes.

Anschließend erfolgt bei einer zweckmäßigen Weiterführung der Ausgestaltung ein Kollabieren zu einem Vollstab oder einer Kapillare.

Im Zusammenhang damit erfolgt bei einer anderen Weiterführung nach dem Aufbau der lichtführenden Schichten ein Aufkollabieren des Mantelrohres auf ein weiteres Substrat. Das weitere Substrat kann entweder ein Vollstab oder ein weiteres Mantelrohr sein.

Bei einer zweckmäßigen Ausführungsform des Verfahrens erfolgt nach dem Aufbau der lichtführenden Schichten ein teilweise oder vollständiger Kollabierprozess zu einer Kapillare bzw. zu einem massiven Stab. Nach dem teilweisen oder vollständigen Kollabierprozess kann sich eine mechanische Bearbeitung zu einem Vieleckstab anschließen.

Die Kollabierprozesse können auch sukzessive erfolgen. Bei einer Ausführungsform erfolgt ein nachfolgendes Aufkollabieren mindestens eines weiteren dotierten und/oder undotierten Mantelrohres oder Halbzeugs. Dabei kann bei einem aufkollabierten dotierten Mantelrohr oder Halbzeug die chemische Zusammensetzung wenigstens eines Dotanden jedes einzelnen Substrats radial einen konstanten, linearen und/oder graduellen Verlauf annehmen. Durch ein derartiges Vorgehen werden unterschiedliche Brechzahlverläufe, insbesondere Gräben, Graduierungen oder konstante Abschnitte radial nach außen hin angestückt und miteinander kombiniert.

Diese Fertigung kann mit mindestens einer weiteren Außenbeschichtung kombiniert werden.

Es können auch Fertigungsschritte vorgesehen sein, bei denen mindestens eine der Schutz-, Zwischen- und/oder Barriereschichten wieder entfernt wird. Vorteilhaft ist es, bei den Kollabierprozessen Gläser gleicher oder ähnlicher chemischer Zusammensetzung zu vereinigen. Die Schutz-, Zwischen- und/oder Barriereschicht kann eine chemische Zusammensetzung aufweisen, die beim Aufbringen des Halbzeugs auf ein weiteres Substrat, die thermischen, physikalischen und/oder chemischen Unterschiede zwischen dem Halbzeug und dem weiteren Substrat, insbesondere die Unterschiede der thermischen Ausdehnungskoeffizienten und/oder die unterschiedlichen chemischen Zusammensetzungen, minimiert, wobei diese Schicht aus mindestens einem Übergangsglas unterschiedlicher chemischer Zusammensetzung besteht.

Dies erhöht die Ausbeute des Prozessschrittes, da zumindest Teile der Gläser als Übergangsgläser verwendet werden können.

In einem finalen Fertigungsschritt kann mindestens eine der Schutz-, Zwischen- und/oder Barriereschichten wenigstens teilweise wieder entfernt werden. Dadurch lassen sich Diffusionsvorgänge innerhalb des inneren Aufbaus induzieren, mit denen sich weitere Modifikationen des Brechzahlprofils erreichen lassen.

Die genannten Fertigungsschritte können mit Oberflächenbehandlungen kombiniert werden. In einem Zwischenschritt und/oder einem finalen Fertigungsschritt wird somit zweckmäßigerweise eine Oberflächenbehandlung, vorzugsweise eine Plasma- und/oder Feuerpolitur ausgeführt.

Das Verfahren soll nun anhand beispielhafter Ausführungsformen näher erläutert werden. Zur Verdeutlichung dienen die Figuren 1 bis 4. Es werden für gleiche bzw. gleichwirkende Teile dieselben Bezugszeichen verwendet.

Es zeigt:

Fig. 1 eine Reihe beispielhafter Bearbeitungsschritte an einem Mantelrohr,

Fig. 2 das Zusammenfügen mehrerer Mantelrohre und eines massiven Stabes zu einem Halbzeug für die Lichtleiterfertigung,

Fig. 3 ein vorteilhaftes Ausführungsbeispiel eines Mantelrohres,

Fig. 4 ein weiteres vorteilhaftes Ausführungsbeispiel eines Mantelrohres.

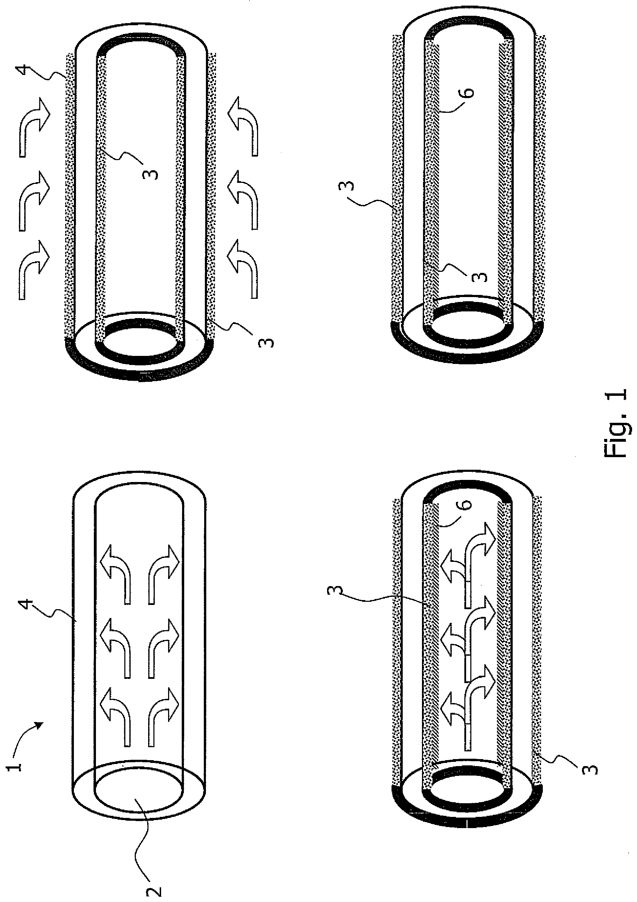

Fig. 1 zeigt eine Reihe beispielhafter Bearbeitungs- und Fertigungsschritte eines Mantelrohrs 1.

Das Mantelrohr besteht im hier vorliegenden Beispiel aus einer Quarzglasröhre einer bestimmten Dicke. Das Quarzglas ist mit einem oder mehreren Brechzahl verändernden Dotanden versehen. Hierbei kann insbesondere auf Fluor, Fluorverbindungen, Germanium, Phosphor, Aluminium, Bor oder auch auf andere Halogene und deren Verbindungen sowie auf andere Stoffe zurückgegriffen werden. Dabei wird die Brechzahl des Mantelrohres so eingestellt, dass diese kleiner als eine Kernbrechzahl des späteren Lichtleiters ist.

Das Mantelrohr dient als Träger für die in den nächsten Schritten ausgeführten Beschichtungen und Oberflächenmodifikationen des Einzelbausteins. In einem ersten Schritt wird auf die innere und/oder äußere Oberfläche 2, 4 des Mantelrohres mindestens eine Schutz-, Zwischen- und Barriereschicht 3 aufgebracht. Diese Schicht ist für die innerhalb des Mantelrohres vorhandene Dotierung im wesentlichen undurchlässig und bedeckt nach dem Beschichtungsvorgang die innere Oberfläche des Mantelrohres gleichmäßig. Sie verhindert ein Ausdiffundieren der Brechzahl verändernden Dotanden aus der Quarzglasmatrix des Mantelrohres während der nächstfolgenden Teilfertigungsschritte.

Zum Ausführen der Beschichtung können die dafür bekannten Beschichtungsverfahren zur Anwendung kommen. Dies betrifft insbesondere nasschemische Tauchverfahren, aber vor allem Abscheidevorgänge aus der Dampf- und Gasphase, die als Chemical Vapor Deposition CVD bekannt sind. Bei den nasschemischen Beschichtungsvorgängen wird das Mantelrohr entweder vollständig in ein Tauchbad gebracht oder es wird von der Abscheidelösung im Inneren durchspült. Zum Ausführen des CVD-Verfahrens wird das Mantelrohr lokal von außen erwärmt und im Inneren von einem Gasstrom durchströmt. Der Gasstrom enthält die für die aufzubringende Schicht vorgesehenen Stoffbestandteile in fein verteilter Form. Diese setzen sich thermophoretisch an der von außen lokal aufgeheizten Stelle des Mantelrohres ab. Zur Beschichtung der gesamten Innenfläche des Mantelrohres wird nun die Stelle der lokalen Erwärmung in Längsrichtung des Mantelrohres verschoben, sodass eine gleichmäßige Innenbeschichtung mit der Schutz-, Zwischen- und Barriereschicht 3 erreicht wird. Die Schutz-, Zwischen- und Barriereschicht besteht vorzugsweise aus Quarzglas mit einem Schmelzpunkt, der über jenem des Mantelrohres liegt. Dadurch übt die Barriereschicht eine zusätzlich stabilisierende Funktion aus.

Weiterhin dient die sowohl innen als auch außen angeordnete Schutz-, Zwischen- und Barriereschicht 3 als ein Haftvermittler und/oder als eine ausgleichende Zwischenschicht, die die Unterschiede zwischen den Ausdehnungskoeffizienten des Materials des Mantelrohres einerseits und den auf die Schutz-, Zwischen- und Barriereschicht 3 folgenden Schichten minimiert. Zum Aufbringen der Schutz-, Zwischen- und Barriereschicht wird auf CVD-Verfahren zurückgegriffen.

Das so mit der Schutzschicht modifizierte Mantelrohr steht nun für weitere, auf dessen Innen- oder Außenfläche auszuführende Beschichtungsvorgänge zur Verfügung. In dem hier vorliegenden Beispiel wird das Mantelrohr auf dessen Innenseite mit einer lichtführenden Beschichtung 6 versehen. Die lichtführende Beschichtung kann mit Germanium dotiert sein. Diese dient als Ausgangsstruktur für die lichtführende Struktur innerhalb des späteren Lichtleiters. Für die innere wie für die äußere Beschichtung können prinzipiell die gleichen Beschichtungsverfahren eingesetzt werden, die auch zum inneren Beschichten des Mantelrohres verwendet werden.

Parallel zu dem vorhergehend beschriebenen ersten Einzelbaustein werden weitere Einzelbausteine, insbesondere ein zweiter und ein dritter Einzelbaustein, sowie ein mit Germanium dotierter Kern gefertigt.

Die Einzelbausteine unterscheiden sich von dem ersten Einzelbaustein in ihrer Beschichtungsfolge. Der zweite Einzelbaustein besteht aus einem mit Fluor dotierten Mantelrohr, das auf dessen Außenseite mit einer Schutz-, Zwischen-und Barriereschicht und auf dessen Innenseite mit einer mit Germanium dotierten Beschichtung versehen ist.

Der dritte Einzelbaustein besteht aus einem ebenfalls mit Fluor dotierten Mantelrohr, das ausschließlich auf dessen Innenfläche eine Schutz-, Zwischen- und Barriereschicht enthält.

Für ein Aufbringen einer äußeren Beschichtung erweist sich die Verwendung eines Plasmaabscheideverfahrens als besonders zweckmäßig. Hierzu wird das Mantelrohr in den Flammenbereich eines darunter befindlichen und entlang der Längsachse des Rohres verschiebbaren Plasmabrenners gebracht und um seine Längsachse gedreht. Innerhalb des Flammenstroms des Plasmabrenners werden die für die äußere lichtleitende Beschichtung vorgesehenen Stoffe zugesetzt. Diese scheiden sich auf der Außenseite des Mantelrohres ab.

Sowohl die Innen- als auch die Außenseite des Mantelrohres können nun weiteren Beschichtungsvorgängen unterzogen werden. Die Zahl der Beschichtungsvorgänge ist prinzipiell beliebig. Dabei lassen sich vor allem auf thermophoretischem Wege innerhalb des Mantelrohres komplexe Schichtstrukturen erzeugen.

In Abhängigkeit von der vorgesehenen Struktur des Halbzeugs bzw. des daraus zu fertigenden Lichtleiters können nun bei Bedarf weitere Modifikationen der Gesamtstruktur erfolgen. Möglich ist hier insbesondere ein Aufbringen einer weiteren Schutz-, Zwischen- und Barriereschicht auf die Außenseite des beschichteten Rohres oder aber auch eine Bearbeitung der äußeren Kontur des Rohres. Dies beinhaltet insbesondere ein Einarbeiten von Abflachungen, ein Überführen der runden äußeren Rohrkontur in eine polygonale, insbesondere eine gleichmäßig hexagonale, oktogonale oder auch eine quadratische Form, oder auch ein Einbringen lokaler Vertiefungen oder in Längsrichtung des Mantelrohres verlaufender Rillen. Derartige Modifikationen können beispielsweise durch ein lokales Ätzen, Laserbehandlungen oder durch Sputterprozesse vorgenommen werden.

Die weiteren an dem Mantelrohr vorgenommenen Herstellungsprozesse richten sich danach, an welche Stelle das Mantelrohr in das zu fertigende Halbzeug eingefügt werden soll. Bei einer Verwendung des Mantelrohres im Kernbereich des späteren Halbzeugs kann ein Kollabierprozess an dem Mantelrohr ausgeführt werden, wobei das Mantelrohr zu einem massiven Kernstab zusammenfällt. Dieser Kollabierprozess kann kontrolliert erfolgen. Dabei wird zwischen der Innen- und der Außenseite des Mantelrohres eine Druckdifferenz eingestellt, die das Mantelrohr mit einer kontrollierbaren Geschwindigkeit und/oder auf einen kontrollierbaren Radius zusammenfallen lässt. Die Druckdifferenz kann entweder durch das Erzeugen eines Unterdrucks im Rohrinnenraum oder durch einen von außen angelegten Überdruck erzeugt werden.

Das Halbzeug wird schließlich aus mehreren derartigen Einzelbausteinen und/oder einem Stab oder einer Kapillare in einem konvergenten Produktionsablauf erzeugt. Das heißt, dass mehrere Mantelrohre und der Stab mit unterschiedlichen Größen, Beschichtungen zeitlich parallel gefertigt und in einem abschließenden Herstellungsprozess miteinander vereinigt werden, wobei die zunächst unabhängigen Produktionsschritte der einzelnen Mantelrohre schließlich in den abschließenden Schritt einmünden, d.h. konvergieren.

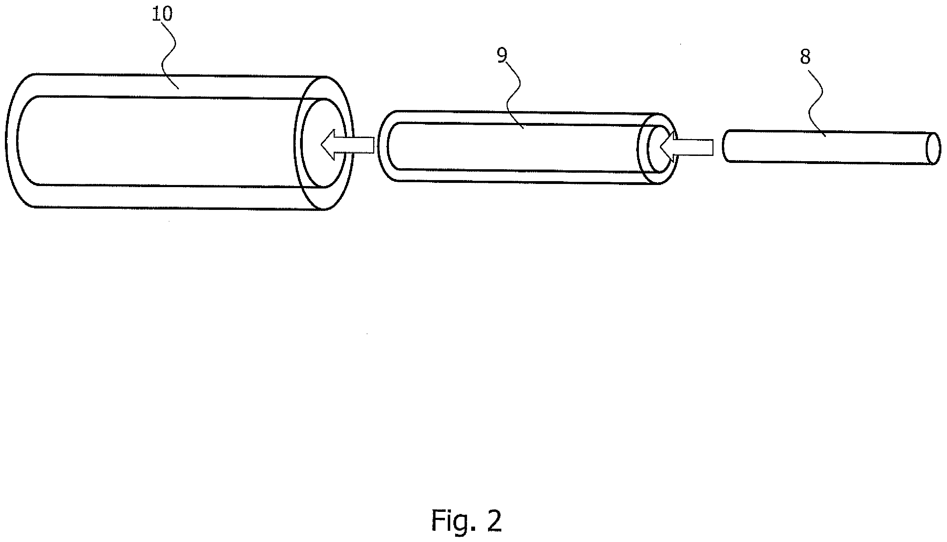

Fig. 2 zeigt den abschließenden konvergierenden Fertigungsprozess zur Herstellung des Halbzeugs. In dem hier vorliegenden Fall ist ein Kernstab 8, ein mittleres Mantelrohr 9 und ein äußeres Mantelrohr 10 vorgesehen. Jedes der Mantelrohre kann die vorhergehend beschriebenen inneren und/oder äußeren Beschichtungen in unterschiedlichen Gestaltungen und Modifikationen aufweisen. Es ist ebenso möglich, dass mindestens eines der Mantelrohre einen von der Kreisform abweichenden Querschnitt aufweist.

Die Vereinigung der Mantelrohre wird als eine Folge von Aufkollabierungen ausgeführt. Dabei dient der Kernstab 8 als Ausgangssubstrat. Diese besteht aus einem vorher kollabierten Mantelrohr, er kann aber auch als Massivstab vorgegeben sein.

Der Kernstab 8 und das mittlere Mantelrohr 9 werden ineinander geschoben. Anschließend wird das mittlere Mantelrohr auf den Kernstab kollabiert. Dieser Kollabiervorgang kann entweder spontan oder unter kontrollierten Bedingungen mit einer eingestellten Druckdifferenz erfolgen. Wichtig sind hierbei die entweder auf der Innenseite des mittleren Mantelrohres oder die auf der Außenseite des Kernstabs vorhandenen Schutz-, Zwischen- und Barriereschichten. Diese bewirken einen Spannungsabbau bzw. einen Spannungsausgleich während des Kollabiervorgangs.

Der gleiche Kollabiervorgang vollzieht sich nun zwischen dem mittleren Mantelrohr 9 und dem äußeren Mantelrohr 10. Nunmehr dient das mit dem Kernstab zusammenkollabierte mittlere Mantelrohr als Substrat zum Aufkollabieren des äußeren Mantelrohrs. Als Resultat entsteht dabei eine durch das Grundmaterial der Mantelrohre einerseits und durch deren innere und äußere Beschichtungen andererseits ausgebildete konzentrische Schichtstruktur aus unterschiedlichen Brechzahlbereichen, die entweder graduell oder sprunghaft ineinander übergehen und insbesondere im Bereich der Beschichtungen der Mantelrohre Graben-oder Stufenstrukturen ausbilden, die nach dem Ziehen des Lichtleiters Brechzahl-Grabenstrukuren ergeben, die auf die jeweils geforderte Biegeempfindlichkeit des Lichtleiters abgestimmt sind.

Die so gebildete Anordnung kann als Ganzes eines Plasma- und/oder Feuerpolitur und/oder einer Temperaturbehandlung unterzogen werden, um so ein spannungsfreies und mit einer einwandfreien Oberfläche versehenes Halbzeug zu erreichen.

Nachfolgend werden weitere Ausführungsbeispiele zur Herstellung der Einzelbausteine sowie des Halbzeugs erläutert.

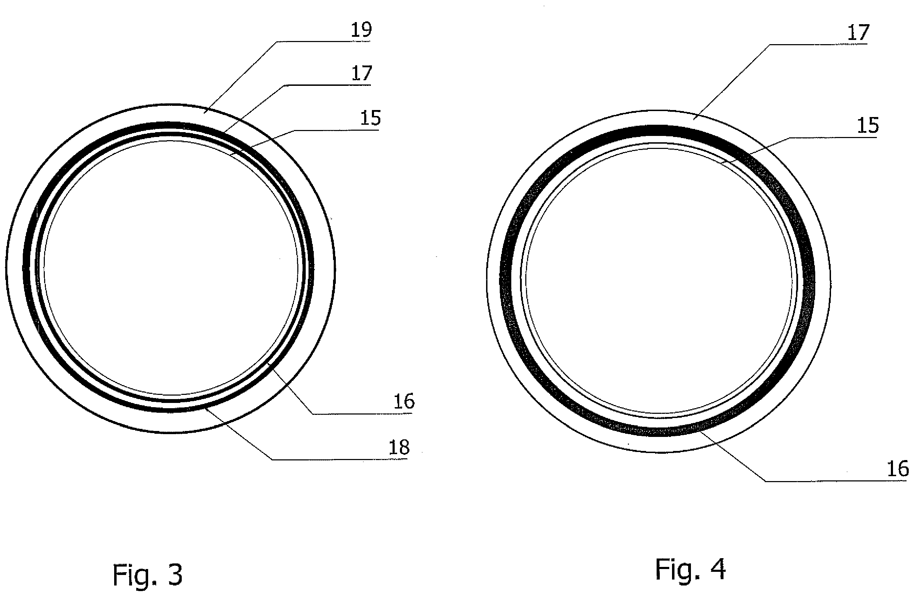

Fig. 3 beschreibt ein vorteilhaftes Ausführungsbeispiel eines Mantelrohrs, beinhaltend eine innere Schutzschicht 15, einen brechzahlabgesenkten Bereich 16, eine undotierte oder dotierte Zwischenschicht 17 , einen weiteren brechzahlabgesenkten Bereich 18 und eine äußere Schutzschicht 19.

Fig. 4 beschreibt ein vorteilhaftes Ausführungsbeispiel eines Mantelrohrs, beinhaltend eine innere Schutzschicht 15, einen brechzahlabgesenkten Bereich 18 und eine äußere Schutzschicht 19. Die Außendurchmesser der Ausführungsbeispiele betragen jeweils 30 bis 40 mm, die Innendurchmesser 25 bis 35 mm.

Zur Rohrfertigung wird in einem ersten Schritt ein Hilfsmaterial bereitgestellt. Dies ist vorzugsweise ein Graphit- oder SiC-Stab, wobei hierbei auch jedwedes andere hitze- und temperaturbeständige Material verwendet werden kann. Im angeführten Beispiel wird ein Graphitstab verwendet.

Im Folgenden erfolgt die Beaufschlagung des Graphitstabs mit der inneren Schutzschicht 15 von 1-2 mm Wandstärke, vorzugsweise 1,5mm, die entweder in Form eines Substratrohrs auf den Graphitstab aufkollabiert oder im Zuge einer Direktbeschichtung auf dem Graphitstab gebildet werden kann. Diese innere Schutzschicht besteht vorzugsweise aus undotiertem Quarzglas, wobei sie aber je nach Anwendungsfall auch zumindest einen Dotanden mit enthalten kann. Nachfolgend erfolgt die Bildung eines fluordotierten Grabens 18 mit einer Wandstärke von 1,5-2,5mm, vorzugsweise 2mm und einer Brechzahlabsenkung von $\Delta n$ zwischen -0,005 und -0,026 , vorzugsweise -0,009, mit Hilfe von Abscheideprozessen, wobei bevorzugt das POVD bzw. MCVD Verfahren oder der sog. Smoker angewendet wird.

Anschließend erfolgt die Aufbringung der äußeren Schutzschicht von 0,2- 3mm vorzugsweise 1mm, entweder durch Aufkollabieren eines Rohres mit gewünschter Glaszusammensetzung oder durch Direktbeschichtung mit zuvor genannten Verfahren.

Nach dem Entfernen des Hilfsmaterials - im vorliegenden Beispiel des Graphitstabs - erfolgt eine Bearbeitung und/oder Reinigung und/oder Temperaturbehandlung der Innenoberfläche.

An diese Prozedur schließt sich ein Streckschritt an, so dass der Außendurchmesser des neuen Rohrs zwischen 24 und 36mm vorzugsweise 32mm beträgt. In diesem Rohr werden die lichtführenden Schichten mit Hilfe des CVD-Verfahrens oder des PIVD Verfahrens abgeschieden, wobei sich die Brechzahl ab einer gewissen Schichtanzahl kontinuierlich erhöht. Abschließend wird das so hergestellte Rohr zu einer Kapillare oder einem massiven Stab kollabiert.

Das daraus entstehende Produkt wird nach der Aufbereitung der äußeren Oberfläche mit wenigstens einem Rohr gewünschter Brechzahl und Wandstärke umfangen oder im Zuge einer Direktbeschichtung mit weiteren Schichten gewünschter Brechzahl und Wandstärke beschichtet. Dadurch wird das korrekte Kern / Mantel -Verhältnis bei der späteren Lichtleitfaser erzeugt.

Bei einem anderen Ausführungsbeispiel erfolgt im ersten Schritt ebenfalls die Bereitstellung eines Hilfsmaterial für die Rohrfertigung, vorzugsweise eines Graphit oder SiC-Stabs, wobei hierbei auch jedwedes andere hitze- und temperaturbeständige Material verwendet werden kann. Im angeführten Beispiel wird ein Graphitstab mit 43 mm Außendurchmesser verwendet.

Im Folgenden erfolgt die Beaufschlagung des Graphitstabs mit einer Glasrußschicht gewünschter Brechzahl. Anschließend erfolgt die Abscheidung der inneren Schutzschicht 15 bevorzugt bestehend aus undotiertem Quarzglas mit einer Dicke zwischen 0,2 - 1,2mm, bevorzugt 0,7mm. Nachfolgend erfolgt die Bildung eines ersten dotierten Grabens 16 mit einer Wandstärke von 0,2-1,3mm, vorzugsweise 0,7mm und einer Brechzahländerung von $\Delta n$ betragsmäßig vorteilhafter Weise zwischen 0,001 und -0,005 , vorzugsweise 0,0025, mit Hilfe von Abscheideprozessen, wobei bevorzugt das POVD bzw. MCVD Verfahren oder der sog. Smoker angewendet wird.

Eine weitere Zwischenschicht aus Quarzglas mit einer Wandstärke zwischen 0,01mm und 2,5mm vorzugsweise 0,7mm wird mit Hilfe der zuvor genannten Verfahren aufgebracht, wobei es sich entweder um undotiertes Quarzglas handelt oder um dotiertes Quarzglas, wobei für diesen Fall für dessen Brechzahldifferenz $\Delta n_2$ vorzugsweise gilt :

$$\Delta n_2 = - \Delta n +/- 0,001$$

Im Anschluss an diese Zwischenschicht 17 erfolgt die Bildung eines fluordotierten Grabens 18 mit einer Wandstärke von 0,3-2,5mm, vorzugsweise 1,0 mm und einer Brechzahlabsenkung von $\Delta n$ zwischen -0,005 und -0,026 , vorzugsweise -0,009. Die restlichen Schritte gleichen denen des Ausführungsbeispieles 1.

Bei einem weiteren Ausführungsbeispiel erfolgt im ersten Schritt die Bereitstellung eines Hilfsmaterial für die Rohrfertigung, vorzugsweise eines Graphit oder SiC-Stabs, wobei hierbei auch jedwedes andere hitze- und temperaturbeständige Material verwendet werden kann. Im angeführten Beispiel wird ein Graphitstab mit 43mm Außendurchmesser verwendet.

Im Folgenden erfolgt die Beaufschlagung des Graphitstabs mit einer Glasrußschicht gewünschter Brechzahl. Diese wird zumindest ansatzweise durch nachfolgende Beschichtungsprozesse zu einer Glasschicht verschmolzen. Nachfolgend erfolgt die Bildung eines fluordotierten Grabens 18 mit einer Wandstärke von 0,4-2,5mm, vorzugsweise 1,5mm und einer Brechzahlabsenkung von $\Delta n$ zwischen -0,004 und -0,026 , vorzugsweise -0,009, mit Hilfe von Abscheideprozessen, wobei bevorzugt das POVD bzw. MCVD Verfahren oder der sog. Smoker angewendet wird. Dieses Rohr wird mit einer äußeren Schutzschicht 19 versehen, das vorzugsweise aus undotiertem Quarzglas besteht und eine Wandstärke zwischen 0,1 und 3mm vorzugsweise 0,5mm aufweist.

Nach dem Entfernen des Hilfsmaterials - im vorliegenden Beispiel des Graphitstabs - erfolgt eine Bearbeitung und/oder Reinigung und/oder Temperaturbehandlung der Innenoberfläche. Es können sich ein oder mehrere Streckprozesse anschließen.

Anschließend wird mit Hilfe von Innenabscheideprozessen, wie beispielsweise MCVD oder PIVD (Plasma Inside Vapor deposition) die gewünschte Brechzahlabfolge hergestellt. Nach Abschluss der Innenbeschichtungen können eine Temperaturbehandlung und/oder Streckprozesse durchgeführt werden. Das daraus entstehende Produkt wird nach der Aufbereitung der äußeren Oberfläche mit wenigstens einem Rohr gewünschter Brechzahl und Wandstärke umfangen oder im Zuge einer Direktbeschichtung mit weiteren Schichten gewünschter Brechzahl und Wandstärke beschichtet. Dadurch wird das korrekte Kern / Mantel -Verhältnis bei der späteren Lichtleitfaser erzeugt.

Es versteht sich von selbst, dass die hier ausgeführten Ausführungsbeispiele in der Abfolge der einzelnen Schritte und Beschichtungsparameter wie Brechzahl, Wandstärke, Durchmesserangaben, Schichtanzahl und Abfolge vom Fachmann gemäß der zu lösenden Aufgabe angepasst werden müssen.

Das Verfahren wurde anhand von beispielhaften Ausführungsformen beschrieben. Weitere Ausführungsformen ergeben sich aus den Unteransprüchen sowie im Rahmen fachmännischen Handelns.

Bezugszeichenliste

1    Mantelrohr
2    Innenseite
3    Schutz-, Zwischen- und Barriereschicht
4    Außenseite
5    lichtführende Beschichtung
6    innere lichtleitende Beschichtung
7    äußere lichtleitende Beschichtung
8    Kernstab
9    mittleres Mantelrohr
10   äußeres Mantelrohr
15   innere Schutzschicht
16   erster dotierter Graben
17   Zwischenschicht
18   fluordotierter Graben
19   äußere Schutzschicht

**Patentansprüche**

1.  Verfahren zur Herstellung eines Halbzeugs zur Fertigung einer biegeoptimierten Lichtleitfaser mit den Schritten:

Bereitstellen mindestens eines als Träger für nachfolgend ausgeführte Beschichtungen und Oberflächenmodifikationen dienenden Mantelrohres (1, 9, 10) mit einer im Vergleich zum lichtführenden Kern niedrigeren Mantelbrechzahl, Aufbringen mindestens einer eine diffusionsverhindernde Sperrfunktion gegenüber flüchtigen Glasbestandteilen besitzende Schutz-, Zwischen- und/oder Barriereschicht (3) auf einer radial äußersten und/oder innersten Rohroberfläche (2, 4) des jeweiligen Mantelrohres, wobei auf der Innenseite und/oder der Außenseite des Mantelrohres ein Aufbau lichtführender Schichten (5, 6, 7) erfolgt, zumindest teilweises Kollabieren und/oder Aufkollabieren des so hergestellten Mantelrohrs zu einer Kapillare oder einem Kernstab (8), **dadurch gekennzeichnet, dass** in einem abschließenden konvergierenden Fertigungsprozess die mit den inneren und/oder äußeren Beschichtungen versehenen Mantelrohre zu dem Halbzeug vereinigt werden, wobei in einer Folge von Aufkollabierungen ein aufkollabierendes Zusammenfügen der Mantelrohre (9, 10) auf den Kernstab (8) zur Herausbildung des Halbzeugs erfolgt, wobei der auf der Innenseite des Mantelrohres erfolgende Aufbau der lichtführenden Schichten mittels eines CVD- oder eines PIVD-Abscheideverfahrens erfolgt, wobei sich die Brechzahl ab einer bestimmten Schichtanzahl kontinuierlich erhöht.

2.  Verfahren nach Anspruch 1, **dadurch gekennzeichnet, dass** das Mantelrohr (1) in Form eines mit Fluor dotierten Quarzglasrohres bereitgestellt wird.

3.  Verfahren nach einem der Ansprüche 1 oder 2, **dadurch gekennzeichnet, dass** der Aufbau lichtführender Schichten (5, 6, 7) mittels eines CVD- und/oder PIVD und/oder OVD Verfahrens, insbesondere eines Plasmaverfahrens, oder einer Flammenpyrolyse ausgeführt wird.

4.  Verfahren nach einem der vorhergehenden Ansprüche, **dadurch gekennzeichnet, dass** die Schutz-, Zwischen- und/oder Barriereschicht (3) vorzugsweise aus Quarzglas mit einem höheren Schmelzpunkt im Vergleich zu dem Schmelzpunkt des Materials des Mantelrohres ausgeführt ist.

5.  Verfahren nach einem der vorhergehenden Ansprüche,

**dadurch gekennzeichnet, dass**
die Schutz-, Zwischen- und/oder Barriereschicht (3) eine chemische Zusammensetzung aufweist, die beim Aufbringen des Halbzeugs auf ein weiteres Substrat, die thermischen, physikalischen und/oder chemischen Unterschiede zwischen dem Halbzeug und dem weiteren Substrat, insbesondere die Unterschiede der thermischen Ausdehnungskoeffizienten und/oder die unterschiedlichen chemischen Zusammensetzungen, minimiert, wobei diese Schicht (3) aus mindestens einem Übergangsglas unterschiedlicher chemischer Zusammensetzung besteht.

6. Verfahren nach einem der vorhergehenden Ansprüche,
**dadurch gekennzeichnet, dass**
nach dem Aufbau der lichtführenden Schichten (5, 6, 7) eine Abscheidung mindestens einer weiteren inneren Schutz-, Zwischen- und/oder Barriereschicht (3) ausgeführt wird.

7. Verfahren nach einem der vorhergehenden Ansprüche,
**dadurch gekennzeichnet, dass**
mit Hilfe mindestens eines Druckregelsystems ein gezieltes Einstellen eines Umgebungsdruckes und/oder eines Rohrinnendruckes erfolgt.

8. Verfahren nach einem der vorhergehenden Ansprüche,
**dadurch gekennzeichnet, dass**
nach dem teilweisen oder vollständigen Kollabierprozess eine mechanische Bearbeitung zu einem Vieleckstab erfolgt.

9. Verfahren nach einem der vorhergehenden Ansprüche,
**dadurch gekennzeichnet, dass**
ein nachfolgendes Aufkollabieren mindestens eines weiteren dotierten und/oder undotierten Mantelrohres oder Halbzeugs erfolgt, wobei bei einem aufkollabierten dotierten Mantelrohr oder Halbzeug die chemische Zusammensetzung wenigstens eines Dotanden jedes einzelnen Substrats radial einen konstanten, linearen und/oder graduellen Verlauf annimmt.

10. Verfahren nach einem der vorhergehenden Ansprüche,
**dadurch gekennzeichnet, dass**
mindestens eine weitere Außenbeschichtung ausgeführt wird.

11. Verfahren nach einem der vorhergehenden Ansprüche,
**dadurch gekennzeichnet, dass**
in einem Zwischenschritt mindestens eine der Schutz-, Zwischen- und/oder Barriereschichten (3) zumindest teilweise wieder entfernt wird.

12. Verfahren nach einem der vorhergehenden Ansprüche,
**dadurch gekennzeichnet, dass**
in einem Zwischenschritt und/oder einem finalen Fertigungsschritt eine Oberflächenbehandlung, vorzugsweise eine Plasma- und/oder Feuerpolitur ausgeführt wird.

**Claims**

1. A method for producing a semi-finished product for producing an optical fiber that is optimized for bending, the method comprising the steps:

providing at least one jacket tube (1, 9, 10) that is used as a carrier for subsequently performed coatings and surface modifications wherein the jacket tube has a lower jacket refractive index than a light conducing core;
applying at least one protective layer, intermediary layer and/or barrier layer (3) providing a diffusion preventing blocking function relative to volatile glass components on a radially outermost and/or innermost tube surface (2, 4) of the respective jacket tube, wherein a build-up of light conducing layers (5, 6, 7) is provided on an inside and/or an outside of the jacket tube,
at least partially collapsing and/or defined collapsing of the jacket tube thus produced into a capillary or a core rod (8),

**characterized in that** the

the jacket tubes provided with inner and/outer coatings are combined into the semi-finished product in a final converging fabrication process wherein the defined collapsing causes a collapsing and joining of the jacket tubes (9, 10) on the core rod (8) in order to form the semi-finished product,
a build-up of the light conducing layers performed on the inside of the jacket tube is performed by a CVD or PIVD deposition method, wherein the refractive index continuously increases with a defined layer number.

2. The method according to claim 1,
**characterized in that**
the jacket tube (1) is provided as a Fluor doted silicone glass tube.

3. The method according to one of the claims 1 or 2,
**characterized in that**
the build-up of the light conducting layers (5, 6, 7) is performed by a CVD and/or PIVD and/or OVD method, in particular a plasma method or by flame pyrolysis.

4. The method according to one of the preceding claims,
   **characterized in that**
   the protective layer, intermediary layer and/or barrier layer (3) is advantageously made from silica glass with a melting point that is higher than a melting point of the material of the jacket tube.

5. The method according to one of the preceding claims,
   **characterized in that**
   the protective layer, the intermediary layer, and/or the barrier layer (3) has a chemical composition which minimizes thermal, physical and/or chemical differences between the semi-finished product and the additional substrate when applying the semi-finished product onto an additional substrate, in particular differences of thermal expansion coefficients and/or different chemical compositions are minimized, wherein the layer (3) is made from at least one transition glass with a different chemical composition.

6. The method according to one of the preceding claims,
   **characterized in that** after building up the light conducting layers (5, 6, 7) a deposition of at least one additional inner protective layer, intermediary layer and/or barrier layer (3) is performed.

7. The method cabinet according to one of the preceding claims,
   **characterized in that**
   a controlled adjustment of an ambient pressure and/or of an interior tube pressure is performed using at least one pressure control system.

8. The method according to one of the preceding claims,
   **characterized in that**
   after partial or complete collapsing machining into a polygonal rod is performed.

9. The method according to one of the preceding claims,
   **characterized in that**
   a subsequent defined collapsing of at least one additional doted and/or un doted jacket tube or semi-finished product is performed, wherein for a jacket tube or semi-finished product that is collapsed onto a defined diameter and doted a chemical composition of at least one dopant of each individual substrate has a radially constant linear and/or gradual distribution.

10. The method according to one of the preceding claims, **characterized in that** at least one additional outer coating is provided.

11. The method according to one of the preceding claims,
    **characterized in that**
    at least one of the protective layers, intermediary layers and/or barrier layers (3) is at least partially removed again in an intermediary step.

12. The method according to one of the preceding claims,
    **characterized in that**
    a surface treatment, advantageously a plasma and/or fire polishing is performed in an intermediary step and/or in a final fabrication step.

**Revendications**

1. Procédé pour la production d'un produit semi-fini pour la fabrication d'une fibre optique optimisée vis-à-vis de la flexion, comprenant les étapes consistant à :

   préparer au moins un tube enveloppe (1, 9, 10), servant de support pour des revêtements exécutés à la suite et pour des modifications de surface,
   avec un indice de réfraction d'enveloppe plus faible par comparaison au coeur qui mène la lumière,
   application d'au moins une couche de protection, couche intermédiaire et/ou couche barrière (3) possédant une fonction de blocage avec empêchement de diffusion vis-à-vis des composantes volatiles du verre,
   sur une surface tubulaire radialement tout à fait extérieure et/ou tout à fait intérieure (2, 4) du tube enveloppe respectif, dans lequel se produit sur la face intérieure et/ou sur la face extérieure du tube enveloppe un empilage de couches (5, 6, 7) qui mènent la lumière,
   rétracter au moins partiellement et/ou comprimer le tube enveloppe ainsi produit pour donner un capillaire ou un barreau de coeur (8),
   **caractérisé en ce que**, dans un processus de fabrication convergent successif, les tubes enveloppe dotés des revêtements intérieurs et/ou extérieurs sont unis pour donner le produit semi-fini, de sorte que dans une succession de rétractions, il se produit un assemblage par compression des tubes enveloppe (9, 10) sur le barreau de coeur (8) pour la formation du produit semi-fini,
   dans lequel, l'empilage des couches qui mènent la lumière, effectué sur la face intérieure du tube enveloppe, a lieu au moyen d'un procédé de déposition du type CVD ou du type PIVD, de sorte que l'indice de réfraction augmente de façon continue à partir d'un certain nombre de couches.

2. Procédé selon la revendication 1, **caractérisé en ce que** le tube enveloppe (1) est préparé sous la forme d'un tube de verre au quartz dopé au fluor.

3. Procédé selon l'une des revendications 1 ou 2, **caractérisé en ce que** l'empilage des couches qui mènent la lumière (5, 6, 7) est exécuté au moyen d'un procédé du type CVD et/ou PIVD et/ou OVD, en particulier d'une procédure au plasma, ou d'une pyrolyse à la flamme.

4. Procédé selon l'une des revendications précédentes, **caractérisé en ce que** la couche de protection, couche intermédiaire et/ou couche barrière (3) est de préférence réalisée en verre de quartz avec une température de fusion plus élevée par comparaison à la température de fusion du matériau du tube enveloppe.

5. Procédé selon l'une des revendications précédentes, **caractérisé en ce que** la couche de protection, couche intermédiaire et/ou couche barrière (3) présente une composition chimique qui, lors de l'application du produit semi-fini sur un autre substrat, minimise les différences thermiques, physiques et/ou chimique entre le produit semi-fini et l'autre substrat, en particulier les différences des coefficients de dilatation thermique et/ou les différences de composition chimique, et cette couche (3) est constituée d'au moins un verre de transition avec une composition chimique différente.

6. Procédé selon l'une des revendications précédentes, **caractérisé en ce que**, après l'empilage des couches qui mènent la lumière (5, 6, 7), on exécute une déposition d'au moins une autre couche de protection, couche intermédiaire et/ou couche barrière intérieure (3).

7. Procédé selon l'une des revendications précédentes, **caractérisé en ce que**, à l'aide d'au moins un système de régulation de pression, il se produit un réglage ciblé d'une pression environnante et/ou d'une pression à l'intérieur du tube.

8. Procédé selon l'une des revendications précédentes, **caractérisé en ce que**, après la procédure de rétraction partielle ou complète, on procède à un traitement mécanique pour donner un barreau polygonal.

9. Procédé selon l'une des revendications précédentes, **caractérisé en ce que** l'on effectue une rétraction successive d'au moins un autre tube enveloppe doper et/ou non dopé ou d'un produit semi-fini, et dans le cas d'un tube enveloppe dopé ou d'un produit semi-fini rétracté, la composition chimique d'au moins un dopant de chaque substrat individuel adopte radialement une évolution constante, linéaire et/ou progressive.

10. Procédé selon l'une des revendications précédentes, **caractérisé en ce que** l'on exécute au moins un autre revêtement extérieur.

11. Procédé selon l'une des revendications précédentes, **caractérisé en ce que**, dans une étape intermédiaire, on élimine à nouveau au moins partiellement l'une au moins des couches de protection, couche intermédiaire et/ou couche barrière (3).

12. Procédé selon l'une des revendications précédentes, **caractérisé en ce que**, dans une étape intermédiaire et/ou dans une étape de fabrication finale, on exécute un traitement de surface, de préférence un polissage au plasma et/ou au feu.

Fig. 1

Fig. 2

Fig. 3

Fig. 4

EP 2 714 603 B1

**IN DER BESCHREIBUNG AUFGEFÜHRTE DOKUMENTE**

**In der Beschreibung aufgeführte Patentdokumente**

- EP 1388525 A2
- JP 2001092233 A
- EP 1256554 A
- DE 60209457 T2
- JP 03016930 B
- US 20060204189 A
- WO 01726 A